# EUROPEAN PATENT SPECIFICATION

(11) **EP 4 432 345 B1**
(45) Date of publication and mention of the grant of the patent: **07.05.2025**
(21) Application number: 23162305.9
(22) Date of filing: 16.03.2023
(51) Int. Cl.: H01L 23/373

(54) **INSULATED METAL SUBSTRATE AND METHOD FOR PRODUCING AN INSULATED METAL SUBSTRATE**
ISOLIERTES METALLSUBSTRAT UND VERFAHREN ZUR HERSTELLUNG EINES ISOLIERTEN METALLSUBSTRATS
SUBSTRAT MÉTALLIQUE ISOLÉ ET PROCÉDÉ DE PRODUCTION D'UN SUBSTRAT MÉTALLIQUE ISOLÉ

(43) Date of publication of application: 18.09.2024
(73) Proprietor: Hitachi Energy Ltd, 8050 Zürich (CH)
(72) Inventor: SANTOLARIA, Lluis, 4600 Olten (CH); GUILLON, David, 8857 Vorderthal (CH); TRUESSEL, Dominik, 5620 Bremgarten (CH); SIROKY, Georg, 4600 Olten (CH)
(74) Representative: Epping - Hermann - Fischer

(56) References cited:
- US-A1- 2003 094 682
- US-A1- 2015 279 754
- US-A1- 2016 071 778
- US-A1- 2017 069 561
- US-A1- 2019 074 238

## Description

The present disclosure relates to an insulated metal substrate for a power semiconductor device and a method for producing an insulated metal substrate.

Document US 2017/069561 A1 describes a power semiconductor module including a substrate having a first side for being arranged to face a heat sink and for being thermally conductively connected to the heat sink, a power semiconductor component arranged on an opposing second side of the substrate, and an electrically insulating housing defining a cavity in which the substrate and the power semiconductor component are accommodated.

Document US 2003/094682 A1 describes a semiconductor module includes a ring-shaped metal frame having a bottom surface for contact with a top surface of an external heat sink (11) and serving as a mounting surface. The ring-shaped metal frame has a flange along an inner periphery thereof for engagement with an outer peripheral part of an insulating substrate at a first main surface of a ceramic plate. The metal frame is fastened to the external heat sink by screws or bonded to the external heat sink with an adhesive. The flange of the metal frame fastened or bonded to the external heat sink presses the outer peripheral part of the insulating substrate toward the external heat sink.

Document US 2015/279754 A1 describes a semiconductor device has an insulating substrate, a semiconductor element which is mounted on the insulating substrate, a hollow casing which surrounds a peripheral edge of the insulating substrate to contain the semiconductor element therein, and a sealing material which is charged into the casing to seal the inside of the casing. The casing has protrusion portions each of which partially protrudes from an upper surface of the casing.

Document US 2019/074238 A1 describes a semiconductor device including a heat sink, a heat dissipation plate, a plurality of semiconductor elements, a plurality of metal terminals, a case, and screws.

Document US 2016/071778 A1 describes a semiconductor device including an insulating substrate, a semiconductor element disposed on a first surface of the insulating substrate, a case connected to the insulating substrate, and a resin filled inside the case.

Embodiments of the disclosure relate to an insulated metal substrate, which is particularly reliable and mechanically stable. A further embodiment of the disclosure relate to a method for producing such an insulated metal substrate.

This is achieved by the subject-matter of the independent claims. Further embodiments are evident from the dependent claims in the following description.

An insulated metal substrate for a power semiconductor device is described. The term "power" here and in the following, for example, refers to power semiconductor devices, power semiconductor modules and/or power semiconductor chips adapted for processing voltages and currents of more than 100 V and/or more than 10 A, exemplary voltages up to 10 kV and currents of amperes up to 5000 A.

According to an embodiment, the insulated metal substrate comprises a metal base. The metal base has a main extension plane extending in lateral directions. The metal base has a back surface and a top surface opposite the back surface. The back surface and the top surface are connected by at least one side surface. The back surface and the top surface both extend, exemplarily, in lateral directions and the at least one side surface extends in vertical direction being perpendicular to the lateral directions. The metal base is formed, in particular, as a plate.

The metal base has a height, for example, in vertical direction of at least 0.5 mm and at most 10 mm, in particular at least 1 mm and at most 2 mm. Exemplarily, the metal base comprises or consists of an electrically conductive material. The metal base comprises or consists in particular of a metal alloy or a metal, such as aluminum and/or copper.

According to the embodiment, the insulated metal substrate comprises a dielectric layer arranged on the metal base. The dielectric layer extends in particular in lateral directions. The dielectric layer has a back surface and a top surface both extending in lateral directions, for example.

For example, the dielectric layer, in particular the back surface of the dielectric layer, is directly arranged on the metal base, in particular the top surface of the metal base. In particular, the dielectric layer is arranged at a first side of the insulated metal substrate. The dielectric layer covers the top surface of the metal base, for example, by at least 80 % or 90 %. Exemplarily, the dielectric layer completely covers the top layer of the metal base.

The dielectric layer has, for example, a height in vertical direction of at least 50 µm and at most 500 µm, in particular at least 100 µm and at most 200 µm. Exemplarily, the dielectric layer comprises or consists of an electrically insulating material.

According to the embodiment, the insulated metal substrate comprises an electrically conductive layer arranged on the dielectric layer. The electrically conductive layer extends in particular in lateral directions. The electrically conductive layer has a back surface and a top surface both extending in lateral directions, for example.

For example, the electrically conductive layer, in particular the back surface of the electrically conductive layer, is directly arranged on the dielectric layer, in particular the top surface of the dielectric layer. In particular, the electrically conductive layer is arranged at the first side of the insulated metal substrate. The electrically conductive layer covers the top surface of the dielectric layer, for example, by at least 50 % or 70 % and/or at most 95 % or 90 %. In particular, the dielectric layer, in particular the top surface of the dielectric layer, is regionally free of the electrically conductive layer.

The electrically conductive layer has, for example, a height in vertical direction of at least 0.1 mm and at most 2.5 mm, in particular at least 0.5 mm and at most 1.0 mm. Exemplarily, the electrically conductive layer comprises or consists of an electrically conductive material. The electrically conductive layer comprises or consists in particular of a metal alloy or a metal, such as aluminum and/or copper.

For example, the metal base, the dielectric layer and the electrically conductive layer are arranged stacked above one another in a stacking direction being the vertical direction perpendicular to the lateral directions.

According to the embodiment, the insulated metal substrate comprises a reinforcement structure. The reinforcement structure has a main extension plane extending in lateral directions. The reinforcement structure has a back surface and a top surface opposite the back surface. The back surface and the top surface are connected by at least two side surfaces, an inner side surface and an outer side surface. The back surface and the top surface both extend, exemplarily, in lateral directions and the at least two side surfaces each extends in vertical direction.

In particular, the reinforcement structure is arranged at the first side of the insulated metal substrate. This is that the reinforcement structure layer faces the top surface of the metal base.

The reinforcement structure has, for example, a height in vertical direction of at least 0.5 mm and at most 8 mm or at most 5 mm. Exemplarily, the reinforcement structure comprises or consists of an electrically conductive material, such as a metal or a metal alloy.

According to the embodiment of the insulated metal substrate, the reinforcement structure is arranged in a peripheral region of the insulated metal substrate at least partially surrounding a central region of the insulated metal substrate.

For example, the inner side surface of the reinforcement structure faces the central region and the outer side surface of the reinforcement structure faces away from the central region. The central region is located at a center of the insulated metal substrate and extends in lateral directions in direction to edges of the insulated metal substrate. The peripheral region extends in lateral directions along the edges of the insulated metal substrate delimiting the central region.

The peripheral region completely surrounds the central region in lateral directions. The reinforcement structure is arranged at least regionally or completely in the peripheral region. For example, the reinforcement structure surrounds the central region in a frame-like manner. "Frame-like" is to be understood as non-limiting with respect to the shape of the reinforcement structure.

Exemplarily, the reinforcement structure is provided connected to the metal base, the dielectric layer and the electrical conductive layer in a mechanically stable manner. This is that the reinforcement structure provides a mechanically stable support for the metal base, the dielectric layer and the electrical conductive layer, thus, reducing or preventing a concave bending of the insulated metal substrate. In particular, a convex bending of the back surface of the insulated metal substrate is achieved. Here and in the following, a concave bending means that the insulated metal substrate is bent, in particular in the central region, in direction to the top surfaces. In other words, a concave bending means that the back surface of the metal base is bent, in particular in the central region, in direction to the electrical conductive layer.

For example, the metal base, the dielectric layer and the electrical conductive layer are a layer stack, which might undergo the bending, in particular the concave bending, during an assembly process, where the layer stack is exposed to heat including phases of heating-up and cooling-down. In particular, the concave bending of the back surface of a metal base of a conventional insulated metal substrate causes several disadvantages when using no reinforcement structure. Such disadvantages are, e.g. an improper thermal interface of the metal base with a heat sink or cracks in the dielectric layer.

In summary, an insulated metal substrate for a power semiconductor device having a reinforcement structure can provide, inter alia, the following advantages. The prevention or at least reduction of the concave bending makes the comparably cost-effective technology of insulated metal substrates usable for large power modules and power modules for higher voltage classes. The reinforcement structure being mechanically rigid can further provide a reduced risk of an isolation breakdown due to cracks in the dielectric layer, caused by stress due to strong bending. Further, such an insulated metal substrate has a reduced concave bending or even a convex bending of the metal base, which is advantageous for a thermal interface between a power module and a cooler. Additionally, such an insulated metal substrate has a reduced long-term increase of a thermal resistance and consequently an increased life-time. Additionally, a reduced bending behaviour due to thermal cycles during operation of the power semiconductor device is achieved, which also improves a long-term behaviour of a thermal interface and consequently a reliability, e.g. less pump-out of thermal interface material. Moreover, such insulated metal substrates have a reduced weight compared to standard setup, where substrates are soldered on a baseplate. Such an insulated metal substrate requires also a reduced number of process steps in the assembly process.

Such insulated metal substrate can be in particular used in low voltage industrial and automotive products.

According to a further embodiment of the insulated metal substrate, the dielectric layer is an electrically insulating resin layer.

The insulated metal substrate exemplarily comprises or consists of an epoxy resin comprising an inorganic filler. The inorganic filler comprises or consists of a ceramic material like aluminium nitride (AlN), silicon nitride (Si3N4), boron nitride (BN), and/or aluminium oxide (Al2O3).

According to a further embodiment of the insulated metal substrate, the electrically conductive layer comprises a circuit metallization. The circuit metallization comprises, for example, a plurality of parts. At least some of the parts are arranged spaced apart from one another in lateral directions. This is that at least some of the parts are electrically insulated from one another.

The circuit metallization is configured, for example, to be connected to at least one power semiconductor device in the central region.

According to a further embodiment of the insulated metal substrate, the reinforcement structure has a height, which is equal or larger than a height of the electrically conductive layer. The height of the reinforcement structure is an extent of the reinforcement layer from the back surface to the top surface in vertical direction. Further, the height of the electrically conductive layer is an extent of the electrically conductive layer from the back surface to the top surface in vertical direction. In particular, all the parts have the same height.

Exemplarily, the top surface of the reinforcement structure protrudes above the top surface of the electrically conductive layer in vertical direction facing away from the metal base.

For example, the height of the reinforcement structure is at most 7.5 mm or 4.5 mm higher than the height of the electrically conductive layer.

Alternatively, the reinforcement structure has a height, which is smaller than a height of the electrically conductive layer. The height of the reinforcement structure is determined in view of the physical properties of the material used for the reinforcement structure. The physical properties can be Young Modulus, thermal expansion coefficient and such other physical properties relating to softness or hardness of the material and its behavior with temperature change. The higher the value of Young modulus, the smaller can be the height or thickness required for the reinforcement structure, determined for materials with similar thermal expansion coefficients (constant coefficient of thermal expansion, CTE values).

According to a further embodiment of the insulated metal substrate, the reinforcement structure is formed continuously. In particular, the reinforcement structure completely encloses the central region in lateral directions. This is that the reinforcement structure is formed continuously connected. Exemplarily, the reinforcement structure is formed as one piece.

Alternatively, the reinforcement structure being formed continuously comprises at least two portions, which are formed of a different material. Exemplarily, the portions are connected to one another.

According to a further embodiment of the insulated metal substrate, the reinforcement structure is formed discontinuously. This is that the reinforcement structure is formed not continuously connected. In particular, the reinforcement structure comprises at least two sections. The sections are exemplarily spaced apart from one another in lateral directions. Exemplarily, the reinforcement structure is formed as separate pieces, i.e. segments.

The segments can be all formed of the same material. Alternatively, at least two of the segments are formed of a different material.

According to a further embodiment of the insulated metal substrate, at least one of a height of the reinforcement structure and a width of the reinforcement structure is uniform. The width of the reinforcement structure is a minimal extent of the reinforcement layer from the inner side surface to the outer side surface in lateral directions.

Exemplarily, the height of the reinforcement structure is the same for every region in the peripheral region. For example, the width of the reinforcement structure is the same for every region in the peripheral region, except corner regions of the insulated metal substrate. For example, at corner regions of the reinforcement structure, a width is increased in comparison to regions where the reinforcement structure extends straight.

For example, the width of the reinforcement structure is at least 1 mm and at most 20 mm or at most 10 mm.

According to a further embodiment of the insulated metal substrate, at least one of a height of the reinforcement structure and a width of the reinforcement structure is nonuniform. Exemplarily, the height of the reinforcement structure is different for at least two regions in the peripheral region. For example, the width of the reinforcement structure is different for at least two regions in the peripheral region.

According to a further embodiment of the insulated metal substrate, the reinforcement structure comprises at least one additional reinforcement structure. For example, the additional reinforcement structure is arranged at the first side of the insulated metal substrate. This is that the additional reinforcement structure layer faces the top surface of the metal base.

The additional reinforcement structure has, for example, a height in vertical direction of at least 0.5 mm and at most 8 mm or at most 5 mm. Exemplarily, the additional reinforcement structure comprises or consists of an electrically conductive material, such as a metal or a metal alloy. The additional reinforcement structure can be formed of the same material than the reinforcement structure or of a different material.

Advantageously, the additional reinforcement structure further increases the mechanically stable support for the metal base, the dielectric layer and the electrical conductive layer, thus, reducing the concave bending of the insulated metal substrate.

According to a further embodiment of the insulated metal substrate, the at least one additional reinforcement structure extends in the central region. In particular, the additional reinforcement structure is arranged in the central region. For example, the additional reinforcement structure extends from the peripheral region in lateral directions in the central region.

According to a further embodiment of the insulated metal substrate, the at least one additional reinforcement structure is formed integrally with the reinforcement structure. This is that the additional reinforcement structure can be formed as one piece with the reinforcement structure. For example, the additional reinforcement structure is continuously connected with the additional reinforcement structure.

Alternatively, the additional reinforcement structure and the reinforcement structure are formed of a different material and which are adhered to one another.

According to a further embodiment of the insulated metal substrate, the at least one additional reinforcement structure is spaced apart from the reinforcement structure. This is that the additional reinforcement structure can be formed as a separate piece with the reinforcement structure. For example, the additional reinforcement structure is not continuously connected with the additional reinforcement structure.

The additional reinforcement structure advantageously improves the mechanical stability of the insulated metal substrate. Advantageously, for an improved suppression or at least reduction of the concave bending in the central region of the insulated metal substrate, the additional reinforcement structure is arranged in the central region or placed on locations, where a strongest bending would occur. According to a further embodiment of the insulated metal substrate, the at least one additional reinforcement structure is configured to divide the central region in at least two segments. For example, the additional reinforcement structure completely extends between opposite side surfaces, i.e. opposite inner side surfaces, of the reinforcement structure.

The reinforcement structure comprises a metal Exemplarily, the height and/or a width of the reinforcement structure and/or the material of the reinforcement structure is predetermined dependent on the bending of the metal base, the dielectric layer and the electrically conductive layer in an assembly process without the reinforcement structure. For example, the layer stack is comparatively flat, i.e. has no bending, at an initial temperature T1 during a joining process, exemplarily with power semiconductor devices. However, the layer stack has, for example, the concave bending during cooling down to a further temperature, being smaller than the initial temperature, due to a "mechanical dominance" of the metal base against the dielectric layer and the electrically conductive layer. This is that the material of the reinforcement structure is predetermined such that the reinforcement structure has a smaller thermal expansion coefficient than the metal base, whose comparably large expansion coefficient results in strong bending during cooling down if no reinforcement structure is available. The thickness of the reinforcement structure is, for example, predetermined by a Young modulus referring to a rigidness of the material of the reinforcement structure. Additionally, a reduced bending behaviour due to thermal cycles during operation of the power semiconductor device is considered, which would also improve long-term behaviour of a thermal interface and consequently a reliability.

At least a flat back surface of the metal base is, inter alia, achieved by the following formula: dmetal_base εmetal_base λmetal_base + ddielectric_layer εdielectric_layer λdielectric_layer = dreinforcment_structure εreinforcment_structure λreinforcment_structure

Wherein d is the corresponding height, ε is the corresponding Young modulus, λ is the corresponding thermal expansion coefficient.

For example, dependent on the height, the Young modulus and the thermal expansion coefficient of the reinforcement structure with respect to the metal base, the dielectric layer and/or the electrically conductive layer, a defined convex bending of the back surface of the metal base is advantageously achievable or at least a concave bending is reduced or suppressed. With such a convex bending, cooling efficiency can be advantageously increased.

According to a further embodiment of the insulated metal substrate, the reinforcement structure is arranged on the metal base. For example, in the peripheral region, the metal base is free of the dielectric layer and the electrically conductive layer. The reinforcement structure is in the peripheral region directly and immediately in contact with the metal base.

According to a further embodiment of the insulated metal substrate, the reinforcement structure is arranged on the dielectric layer. For example, the top surface of the metal base is completely covered with the dielectric layer and the top surface of the dielectric layer is free of the electrically conductive layer in the peripheral region. The reinforcement structure is in the peripheral region directly and immediately in contact with the dielectric layer.

Exemplary, the additional reinforcement structure is arranged on the dielectric layer. This is that the top surface of the dielectric layer is free of the electrically conductive layer in the central region, where the additional reinforcement structure is arranged.

According to a further embodiment of the insulated metal substrate, the reinforcement structure is arranged on the electrically conductive layer. For example, the top surface of the metal base is completely covered with the dielectric layer. The electrically conductive layer is arranged in the peripheral region on the dielectric layer. This is that at least one of the parts are arranged in the peripheral region. The reinforcement structure is in the peripheral region directly and immediately in contact with the electrically conductive layer.

Exemplary, the additional reinforcement structure is arranged on the electrically conductive layer. This is that the additional reinforcement structure is arranged, for example, in the central region on one of at least one of the parts.

According to a further embodiment of the insulated metal substrate, an electric potential of the reinforcement structure is grounded. Exemplary, the reinforcement structure and/or the additional reinforcement structure are electrically conductive connected to the electrical conductive layer or the metal base.

Alternatively, the electric potential of the reinforcement structure is floating. This is, for example, that the reinforcement structure does not have any electrically conductive connection to the electrical conductive layer or the metal base.

According to a further embodiment of the insulated metal substrate, the reinforcement structure is grounded by at least one screw and/or the reinforcement structure is grounded by at least one bonding wire. For example, the reinforcement structure is electrically conductively connected to the metal base via the screw and/or the bonding wire or with a part of the circuit metallization. Alternatively, the reinforcement structure is directly electrically conductively connected to a base material of the metal base. In particular, the metal base is connected to the ground of the insulated metal substrate.

Exemplarily, the reinforcement structure comprises at least one opening, completely penetrating the reinforcement structure in vertical direction. The opening is configured to receive the screw or a bolt, with which the reinforcement structure can be connected to the metal base and additionally with which the insulated metal substrate or a complete power module can be connected to a cooler or heat sink. Furthermore, the dielectric layer and/or the electrically conductive connection comprises at least one further opening. The further opening completely overlaps with the opening in lateral directions, in particular congruently.

Furthermore, a method for producing an insulated metal substrate is described here, with which an insulated metal substrate as described herein above can be produced or is produced. Therefore, the features in connection with the insulated metal substrate are disclosed also in connection with the method and vice versa.

According to an embodiment of the method, a metal base is provided.

According to an embodiment of the method, a dielectric layer is provided, which is arranged on the metal base.

According to an embodiment of the method, an electrically conductive layer is provided, which is arranged on the dielectric layer. Exemplarily, a material of the conductive layer is applied on the dielectric layer. The material of the conductive layer completely covers the top surface of the dielectric layer. For example, after the application of the material of the conductive layer, the material of the conductive layer is structured to the electrically conductive layer. The structuring is achieved, for example, with a chemical etching process and/or a physical etching process.

Alternatively, the metal base and the parts of the circuit metallization are provided and the dielectric layer is molded.

According to an embodiment of the method, a reinforcement structure is provided, wherein the reinforcement structure is provided in a peripheral region of the insulated metal substrate.

Furthermore, such a method for an insulated metal substrate has advantageously a reduction of process steps in an assembly process, as e.g. no process for joining of substrates to a baseplate is needed.

According to an embodiment of the method, the reinforcement structure is applied to at least one of the metal base, the dielectric layer and the electrically conductive layer. In particular, the reinforcement structure is prefabricated and applied to at least one of the metal base, the dielectric layer and the electrically conductive layer.

According to an embodiment of the method, the reinforcement structure is applied by at least one of the following processes: lamination, gluing, soldering, sintering, brazing, gluing, screwing.

According to an embodiment of the method, the reinforcement structure is produced from a base material of the metal base. Exemplarily, the base material of the metal base is provided. After the provision of the base material of the metal base, the base material is structured to the metal base and the reinforcement structure from an integral structure, i.e. the base material. The structuring is achieved, for example, with an etching process or a grinding process.

The accompanying Figures are included to provide a further understanding. In the Figures, elements of the same structure and/or functionality may be referenced by the same reference signs. It is to be understood that the embodiments shown in the Figures are illustrative representations and are not necessarily drawn to scale.

Figure 1 is a schematic three dimensional view of an insulated metal substrate according to an exemplary embodiment,

Figures 2 and 3 each is a schematic three dimensional cross-sectional view of an insulated metal substrate each according to an exemplary embodiment, and

Figure 4 is a simulation of a vertical displacement of an insulated metal substrate according to an exemplary embodiment dependent on a height of the reinforcement structure for different materials of the reinforcement structure.

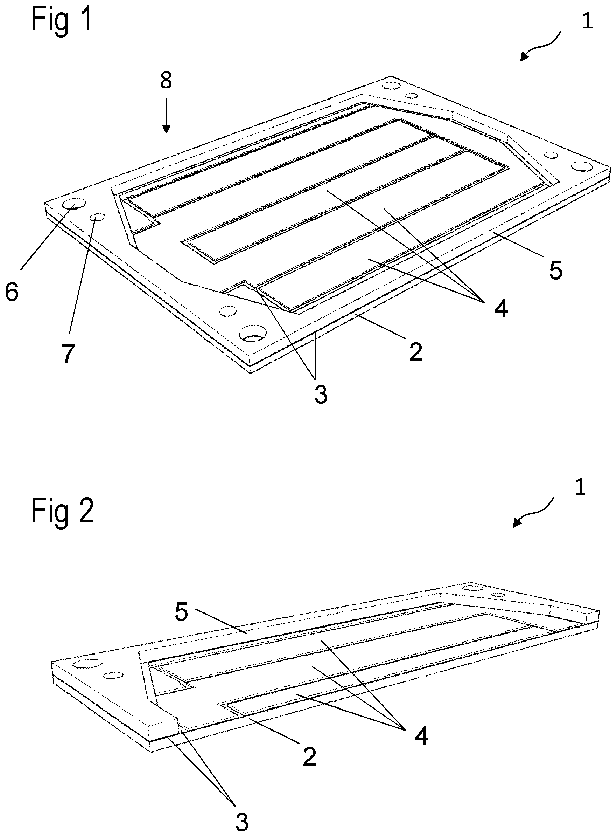

The insulated metal substrate 1 according to the exemplary embodiment of Figure 1 comprises a metal base 2, a dielectric layer 3 and an electrically conductive layer 4 arranged stacked above one another in a stacking direction being a vertical direction.

A top surface of the metal base 2 is completely covered with the dielectric layer 3. The dielectric layer 3 is arranged on the top surface at a first side of the insulated metal substrate 1. Furthermore, the dielectric layer 3 is an electrically insulating resin layer being formed electrically insulating.

The electrically conductive layer 4 is arranged on a top surface of the dielectric layer 3 at the first side 8. Furthermore, the electrically conductive layer 4 comprises a circuit metallization being formed electrically conductive. This is that the electrically conductive layer 4 comprises a plurality of parts, wherein at least some of the parts are spaced apart from one another in lateral directions, which extend perpendicular to the vertical direction.

The metal base 2, the dielectric layer 3 and the electrically conductive layer 4 are formed, in particular, as a layer stack. The metal base 2, the dielectric layer 3 and the electrically conductive layer 4 each have a height. The height of the metal base 2 is formed uniform over its extension. The height of the dielectric layer 3 is formed uniform over its extension. The height of the electrically conductive layer 4, in particular the parts, is formed uniform over its extension. "Uniform" means that each of the heights can vary slightly, i.e. at least by at most 5 %, due to production tolerances. The same is applicable with respect to a uniform width.

The insulated metal substrate 1 has in addition a reinforcement structure 5, which is arranged in a peripheral region of the insulated metal substrate 1 surrounding a central region of the insulated metal substrate 1. In particular, the reinforcement structure 5 is arranged on the top surface of the dielectric layer 3 at the first side 8. The reinforcement structure 5 is in direct contact to the dielectric layer 3.

In particular, the metal base 2 and the dielectric layer 3 both have a mainly quadrangular shape. Mainly means that the quadrangular shape has chamfered corners or rounded corners. Further, an outer side surface of the reinforcement structure 5 has a quadrangular contour and an inner side surface being opposite the outer side surface and facing the central region has an octangular contour. A distance in lateral directions of the outer side surface to the inner side surface defines a width of the reinforcement structure 5. The width of the reinforcement structure 5 increases in direction to corners of the quadrangular contour.

The top surface of the dielectric layer 3 is free of the electrically conductive layer 4 in the peripheral region, in which the reinforcement structure 5 is arranged. This is that the electrically conductive layer 4 is solely arranged in the central region, which is completely surrounded in lateral directions by the reinforcement structure 5.

The reinforcement structure 5 has a height in vertical direction, which is larger than the height of the electrically conductive layer 4. In particular, the height of the reinforcement structure 5 is at most 4.5 mm higher than the height of the electrically conductive layer 4.

In each region of each of the corners of the quadrangular contour, an opening 6 is arranged. Each of the openings 6 is configured to receive a screw, with which the reinforcement structure 5 is grounded to the metal base 2.

Further, in each of the regions of each of the corners of the quadrangular contour, a recess 7 is arranged spaced apart in lateral directions from the opening 6. Each of the recesses 7 has a smaller circumference than the openings 6. Exemplarily, the recesses 7 are configured to receive adjustment pins of a part of a power semiconductor component or a part of a power semiconductor module configured to be mounted on the insulated metal substrate 1.

The exemplary embodiment of Figure 2 relates to the exemplary embodiment of Figure 1. The reinforcement structure 5 is arranged directly on the dielectric layer 3 in the peripheral region completely surrounding the central region.

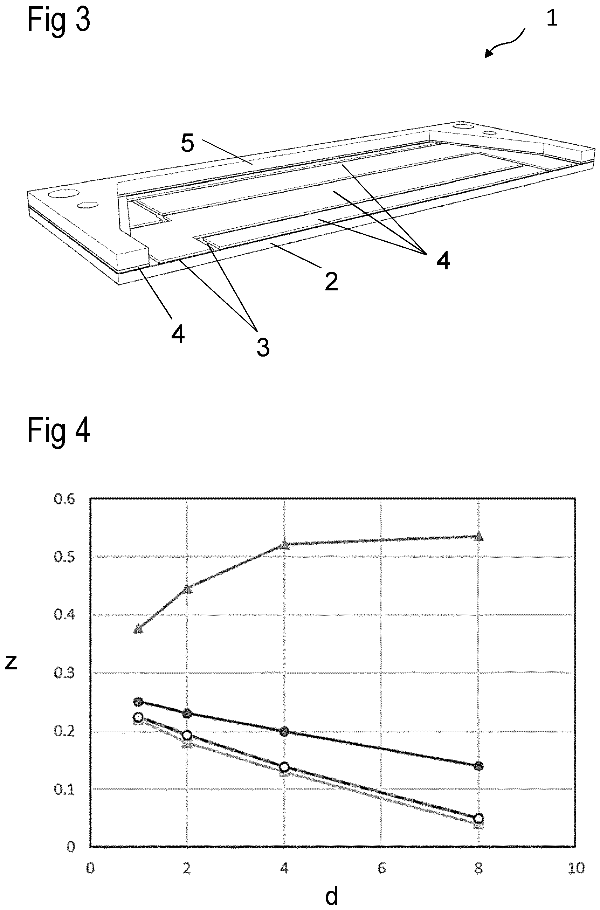

In contrast to the exemplary embodiment of Figure 2, the reinforcement structure 5 is arranged on the electrically conductive layer 4 in the exemplary embodiment of Figure 3. One of the parts of the electrically conductive layer 4 is arranged in the peripheral region. The one of the parts in the peripheral region is spaced apart from the other parts of the electrically conductive layer 4 in the central region in lateral directions.

Exemplarily, finite element simulations show an impact of a height of the reinforcement structure 5 and a material of the reinforcement structure 5 on a bending of the insulated metal substrate 1 due to cooling down by 100 K, as exemplarily shown in Figure 4.

The insulated metal substrate 1 used for an exemplary simulation has a metal base 2 being formed of copper. For example, the reinforcement structure 5 of the insulated metal substrate 1 used for the exemplary simulation is formed of aluminium. At an initial temperature T1, the insulated metal substrate 1, in particular the metal base 2, is assumed to be flat and stress-free.

Exemplarily the exemplary simulation is performed for different heights of the reinforcement structure 5, i.e. being 2 mm, 4 mm, and 8 mm. A vertical difference, corresponding to an unwanted concave bending of the back surface of the metal base 2, after cooling down by 100 K is defined by a vertical difference between a highest and a lowest point of the back surface of the metal base 2 in vertical direction. The simulation results in a vertical difference of 0.22 mm for a height of 1 mm, 0.18 mm for 2 mm, 0.13 mm for 4 mm, and 0.04 mm for 8 mm.

This is that the vertical differences, i.e. the bending of the insulated metal substrate 1 is dependent on the height of the reinforcement structure 5.

The diagram according to Figure 4 shows simulation results similar to the exemplary simulation and an impact of different materials of the reinforcement structure 5, in particular with respect to Young modulus, a thermal expansion coefficient, and of different heights of the reinforcement structure 5. Vertical differences, z, are depicted on the y-axis in mm and heights of the reinforcement structure 5, d, are depicted on the x-axis of the diagram.

The simulation points being characterised by triangles correspond to a reinforcement structure 5 comprising iron-nickel alloy. The simulation points being characterised by filled circles correspond to a reinforcement structure 5 comprising copper. The simulation points being characterised by squares correspond to a reinforcement structure 5 comprising aluminium. The simulation points being characterised by open circles correspond to a reinforcement structure 5 comprising a magnesium alloy or stainless steel.

A strongest reduction in bending is achieved, if the reinforcement structure 5 comprises aluminium, magnesium alloy, or stainless steel.

A weaker reduction in bending can be achieved, if the reinforcement structure 5 comprises copper.

If the reinforcement structure 5 comprises the iron-nickel alloy, the opposite effect of a stronger bending is achieved, which increases with increasing the height of the reinforcement structure 5. In particular, the iron-nickel alloy has a smaller thermal expansion coefficient than the metal base 2, whereas all other materials of the reinforcement structure 5 have a higher thermal expansion coefficient than the metal base 2.

### Reference Signs

- 1: insulated metal substrate
- 2: metal base
- 3: dielectric layer
- 4: electrically conductive layer
- 5: reinforcement structure
- 6: opening
- 7: recess
- 8: first side

## Claims

1. Insulated metal substrate (1) for a power semiconductor device comprising
- a metal base (2),
- a dielectric layer (3) arranged on the metal base (2),
- an electrically conductive layer (4) arranged on the dielectric layer (3), and
- a reinforcement structure (5), wherein
- the reinforcement structure (5) is arranged in a peripheral region of the insulated metal substrate (1) at least partially surrounding a central region of the insulated metal substrate (1),
- the reinforcement structure (5) does not protrude beyond the metal base (2) in lateral directions, and
- the reinforcement structure (5) consists of a metal.

2. Insulated metal substrate (1) according to claim 1, wherein at least one of
- the dielectric layer (3) is an electrically insulating resin layer,
- the electrically conductive layer (4) comprises a circuit metallization.

3. Insulated metal substrate (1) according to one of claims 1 or 2, wherein
- the reinforcement structure (5) has a height, which is equal or larger than a height of the electrically conductive layer (4).

4. Insulated metal substrate (1) according to one of claims 1 to 3, wherein
- the reinforcement structure (5) is formed continuously.

5. Insulated metal substrate (1) according to one of claims 1 to 3, wherein
- the reinforcement structure (5) is formed discontinuously.

6. Insulated metal substrate (1) according to one of claims 1 to 5, wherein
- at least one of a height of the reinforcement structure (5) and a width of the reinforcement structure (5) is uniform, and/or
- at least one of a height of the reinforcement structure (5) and a width of the reinforcement structure (5) is nonuniform.

7. Insulated metal substrate (1) according to one of claims 1 to 6, wherein
- the reinforcement structure (5) comprises at least one additional reinforcement structure, and
- the at least one additional reinforcement structure extends in the central region.

8. Insulated metal substrate (1) according to claim 7, wherein
- the at least one additional reinforcement structure is formed integrally with the reinforcement structure (5), or
- the at least one additional reinforcement structure is spaced apart from the reinforcement structure (5).

9. Insulated metal substrate (1) according to one of claims 7 or 8, wherein
- the at least one additional reinforcement structure (5) is configured to divide the central region in at least two segments.

10. Insulated metal substrate (1) according to one of claims 1 to 9, wherein at least one of
- the reinforcement structure (5) is arranged on the metal base (2),
- the reinforcement structure (5) is arranged on the dielectric layer (3), and
- the reinforcement structure (5) is arranged on the electrically conductive layer (4).

11. Insulated metal substrate (1) according to one of claims 1 to 10, wherein
- an electric potential of the reinforcement structure (5) is grounded, and
- the reinforcement structure (5) is grounded by at least one screw and/or the reinforcement structure (5) is grounded by at least one bonding wire.

12. Method for producing an insulated metal substrate (1) for a power semiconductor device comprising
- providing a metal base (2),
- providing a dielectric layer (3), which is arranged on the metal base (2),
- providing an electrically conductive layer (4), which is arranged on the dielectric layer (3), and
- providing a reinforcement structure (5), wherein
- the reinforcement structure (5) is provided in a peripheral region of the insulated metal substrate (1),
- the reinforcement structure (5) does not protrude beyond the metal base (2) in lateral directions, and
- the reinforcement structure (5) consists of a metal.

13. Method according to claim 12, wherein
- the reinforcement structure (5) is applied to at least one of the metal base (2), the dielectric layer (3) and the electrically conductive layer (4), and
- the reinforcement structure (5) is applied by at least one of the following processes: lamination, gluing, soldering, sintering, brazing, screwing.

14. Method according to claim 12, wherein
- the reinforcement structure (5) is produced from a base material of the metal base (2).

## Patentansprüche

1. Isoliertes Metallsubstrat (1) für eine Leistungshalbleitervorrichtung, umfassend
- eine Metallbasis (2),
- eine dielektrische Schicht (3), die auf der Metallbasis (2) angeordnet ist,
- eine elektrisch leitfähige Schicht (4), die auf der dielektrischen Schicht (3) angeordnet ist, und
- eine Verstärkungsstruktur (5), wobei
- die Verstärkungsstruktur (5) in einem Umfangsbereich des isolierten Metallsubstrats (1) angeordnet ist, der einen zentralen Bereich des isolierten Metallsubstrats (1) zumindest teilweise umgibt,
- die Verstärkungsstruktur (5) in lateralen Richtungen nicht über die Metallbasis (2) hinausragt, und
- die Verstärkungsstruktur (5) aus einem Metall besteht.

2. Isoliertes Metallsubstrat (1) nach Anspruch 1, wobei mindestens eines von Folgendem gilt
- die dielektrische Schicht (3) ist eine elektrisch isolierende Harzschicht,
- die elektrisch leitfähige Schicht (4) besteht aus einer Schaltungsmetallisierung.

3. Isoliertes Metallsubstrat (1) nach einem der Ansprüche 1 oder 2, wobei
- die Verstärkungsstruktur (5) eine Höhe aufweist, die gleich oder größer als eine Höhe der elektrisch leitfähigen Schicht (4) ist.

4. Isoliertes Metallsubstrat (1) nach einem der Ansprüche 1 bis 3, wobei
- die Verstärkungsstruktur (5) durchgehend ausgebildet ist.

5. Isoliertes Metallsubstrat (1) nach einem der Ansprüche 1 bis 3, wobei
- die Verstärkungsstruktur (5) nicht durchgehend ausgebildet ist.

6. Isoliertes Metallsubstrat (1) nach einem der Ansprüche 1 bis 5, wobei
- eine Höhe der Verstärkungsstruktur (5) und/oder eine Breite der Verstärkungsstruktur (5) einheitlich ist, und/oder
- eine Höhe der Verstärkungsstruktur (5) und/oder eine Breite der Verstärkungsstruktur (5) nicht einheitlich ist.

7. Isoliertes Metallsubstrat (1) nach einem der Ansprüche 1 bis 6, wobei
- eine Verstärkungsstruktur (5) mindestens eine zusätzliche Verstärkungsstruktur umfasst, und
- sich die mindestens eine zusätzliche Verstärkungsstruktur in dem zentralen Bereich erstreckt.

8. Isoliertes Metallsubstrat (1) nach Anspruch 7, wobei
- die mindestens eine zusätzliche Verstärkungsstruktur integral mit der Verstärkungsstruktur (5) ausgebildet ist, oder
- die mindestens eine zusätzliche Verstärkungsstruktur von der Verstärkungsstruktur (5) beabstandet ist.

9. Isoliertes Metallsubstrat (1) nach einem der Ansprüche 7 oder 8, wobei
- die mindestens eine zusätzliche Verstärkungsstruktur (5) dazu ausgelegt ist, den zentralen Bereich in mindestens zwei Segmente zu unterteilen.

10. Isoliertes Metallsubstrat (1) nach einem der Ansprüche 1 bis 9, wobei mindestens eines von Folgendem gilt
- die Verstärkungsstruktur (5) ist auf der Metallbasis (2) angeordnet,
- die Verstärkungsstruktur (5) ist auf der dielektrischen Schicht (3) angeordnet, und
- die Verstärkungsstruktur (5) ist auf der elektrisch leitfähigen Schicht (4) angeordnet.

11. Isoliertes Metallsubstrat (1) nach einem der Ansprüche 1 bis 10, wobei
- ein elektrisches Potential der Verstärkungsstruktur (5) geerdet ist, und
- die Verstärkungsstruktur (5) durch mindestens eine Schraube geerdet ist und/oder die Verstärkungsstruktur (5) durch mindestens einen Bonddraht geerdet ist.

12. Verfahren zum Herstellen eines isolierten Metallsubstrats (1) für eine Leistungshalbleitervorrichtung, umfassend
- Bereitstellen einer Metallbasis (2),
- Bereitstellen einer dielektrischen Schicht (3), die auf der Metallbasis (2) angeordnet ist,
- Bereitstellen einer elektrisch leitfähigen Schicht (4), die auf der dielektrischen Schicht (3) angeordnet ist, und
- Bereitstellen einer Verstärkungsstruktur (5), wobei
- die Verstärkungsstruktur (5) in einem Umfangsbereich des isolierten Metallsubstrats (1) bereitgestellt ist,
- die Verstärkungsstruktur (5) in lateralen Richtungen nicht über die Metallbasis (2) hinausragt, und
- die Verstärkungsstruktur (5) aus einem Metall besteht.

13. Verfahren nach Anspruch 12, wobei
- die Verstärkungsstruktur (5) auf die Metallbasis (2), die dielektrische Schicht (3) und/oder die elektrisch leitfähige Schicht (4) aufgebracht wird, und
- die Verstärkungsstruktur (5) durch mindestens eine der folgenden Prozesse aufgebracht wird: Lamination, Kleben, Löten, Sintern, Hartlöten, Schrauben.

14. Verfahren nach Anspruch 12, wobei
- die Verstärkungsstruktur (5) aus einem Basismaterial der Metallbasis (2) hergestellt wird.

## Revendications

1. Substrat métallique isolé (1) pour un dispositif semiconducteur de puissance comprenant
- une base métallique (2),
- une couche diélectrique (3) agencée sur la base métallique (2),
- une couche électroconductrice (4) agencée sur la couche diélectrique (3), et
- une structure de renforcement (5),
- la structure de renforcement (5) étant agencée dans une région périphérique du substrat métallique isolé (1) entourant au moins partiellement une région centrale du substrat métallique isolé (1),
- la structure de renforcement (5) ne faisant pas saillie au-delà de la base métallique (2) dans des directions latérales, et
- la structure de renforcement (5) étant constituée d'un métal.

2. Substrat métallique isolé (1) selon la revendication 1, dans lequel au moins une couche parmi
- la couche diélectrique (3) est une couche de résine électriquement isolante,
- la couche électroconductrice (4) comprend une métallisation de circuit.

3. Substrat métallique isolé (1) selon l'une des revendications 1 ou 2, dans lequel
- la structure de renforcement (5) a une hauteur, qui est égale ou supérieure à une hauteur de la couche électroconductrice (4).

4. Substrat métallique isolé (1) selon l'une des revendications 1 à 3, dans lequel
- la structure de renforcement (5) est formée de manière continue.

5. Substrat métallique isolé (1) selon l'une des revendications 1 à 3, dans lequel
- la structure de renforcement (5) est formée de manière discontinue.

6. Substrat métallique isolé (1) selon l'une des revendications 1 à 5, dans lequel
- au moins un élément parmi une hauteur de la structure de renforcement (5) et une largeur de la structure de renforcement (5) est uniforme, et/ou
- au moins un élément parmi une hauteur de la structure de renforcement (5) et une largeur de la structure de renforcement (5) est non uniforme.

7. Substrat métallique isolé (1) selon l'une des revendications 1 à 6, dans lequel
- la structure de renforcement (5) comprend au moins une structure de renforcement supplémentaire, et
- l'au moins une structure de renforcement supplémentaire s'étend dans la région centrale.

8. Substrat métallique isolé (1) selon la revendication 7, dans lequel
- l'au moins une structure de renforcement supplémentaire est formée d'un seul tenant avec la structure de renforcement (5), ou
- l'au moins une structure de renforcement supplémentaire est espacée de la structure de renforcement (5).

9. Substrat métallique isolé (1) selon l'une des revendications 7 ou 8, dans lequel
- l'au moins une structure de renforcement supplémentaire (5) est configurée pour diviser la région centrale en au moins deux segments.

10. Substrat métallique isolé (1) selon l'une des revendications 1 à 9, dans lequel au moins un agencement parmi
- la structure de renforcement (5) est agencée sur la base métallique (2),
- la structure de renforcement (5) est agencée sur la couche diélectrique (3), et
- la structure de renforcement (5) est agencée sur la couche électroconductrice (4).

11. Substrat métallique isolé (1) selon l'une des revendications 1 à 10, dans lequel
- un potentiel électrique de la structure de renforcement (5) est mis à la terre, et
- la structure de renforcement (5) est mise à la terre par au moins une vis et/ou la structure de renforcement (5) est mise à la terre par au moins un fil de connexion.

12. Procédé de fabrication d'un substrat métallique isolé (1) pour un dispositif semiconducteur de puissance comprenant
- la fourniture d'une base métallique (2),
- la fourniture d'une couche diélectrique (3), qui est agencée sur la base métallique (2),
- la fourniture d'une couche électroconductrice (4), qui est agencée sur la couche diélectrique (3), et
- la fourniture d'une structure de renforcement (5),
- la structure de renforcement (5) étant agencée dans une région périphérique du substrat métallique isolé (1),
- la structure de renforcement (5) ne faisant pas saillie au-delà de la base métallique (2) dans des directions latérales, et
- la structure de renforcement (5) étant constituée d'un métal.

13. Procédé selon la revendication 12, dans lequel
- la structure de renforcement (5) est appliquée à au moins un élément parmi la base métallique (2), la couche diélectrique (3) et la couche électroconductrice (4), et
- la structure de renforcement (5) est appliquée par au moins l'un des procédés suivants : lamination, collage, soudure, frittage, brasage, vissage.

14. Procédé selon la revendication 12, dans lequel
- la structure de renforcement (5) est produite à partir d'un matériau de base de la base métallique (2).
